# FASCICULE DE BREVET EUROPEEN

(11) **EP 2 675 936 B1**
(45) Date de publication et mention de la délivrance du brevet: **29.10.2014**
(21) Numéro de dépôt: 12705440.1
(22) Date de dépôt: 07.02.2012
(51) Int. Cl.: C23C 14/22, H01J 37/301, H01J 37/317

(54) **DISPOSITIF DE SYNTHESE D'UN MATERIAU COMPOSITE NANOSTRUCTURE ET PROCEDE ASSOCIE**
VORRICHTUNG ZUR SYNTHETISIERUNG EINES NANOSTRUKTURIERTEN VERBUNDMATERIALS UND ZUGEHÖRIGES VERFAHREN
DEVICE FOR SYNTHESISING A NANOSTRUCTURED COMPOSITE MATERIAL, AND ASSOCIATED METHOD

(30) Priorité: 14.02.2011 FR 1100447
(43) Date de publication de la demande: 25.12.2013
(73) Titulaire: Commissariat à l'Énergie Atomique et aux Énergies Alternatives, 75015 Paris (FR)
(72) Inventeur: LECONTE, Yann, F-78470 Saint Remy Les Chevreuse (FR); PAQUEZ, Xavier, F-91440 Bures-sur-Yvette (FR); SUBLEMONTIER, Olivier, F-92260 Fontenay Aux Roses (FR)
(74) Mandataire: Reboussin, Yohann Mickaël Noël
(86) Numéro de dépôt international: PCT/IB2012/050549
(87) Numéro de publication internationale: WO 2012/110914

(56) Documents cités:
- US-A1- 2010 227 142
- PIAZZONI C ET AL: "Nanocomposite TiN films with embedded MoS2 inorganic fullerenes produced by combining supersonic cluster beam deposition with cathodic arc reactive evaporation", APPLIED PHYSICS A; MATERIALS SCIENCE & PROCESSING, SPRINGER, BERLIN, DE, vol. 90, no. 1, 3 octobre 2007 (2007-10-03), pages 101-104, XP019562019, ISSN: 1432-0630, DOI: 10.1007/S00339-007-4292-2
- PERZ A ET AL: "CLUSTER ASSEMBLED MATERIALS: A NOVEL CLASS OF NANOSTRUCTURED SOLIDSWITH ORIGINAL STRUCTURES AND PROPERTIES", JOURNAL OF PHYSICS D. APPLIED PHYSICS, IOP PUBLISHING, BRISTOL, GB, vol. 30, no. 5, 7 mars 1997 (1997-03-07), pages 709-721, XP000693040, ISSN: 0022-3727, DOI: 10.1088/0022-3727/30/5/003
- WEGNER K ET AL: "Cluster beam deposition: a tool for nanoscale science and technology", JOURNAL OF PHYSICS D (APPLIED PHYSICS) IOP PUBLISHING UK, vol. 39, no. 22, 21 novembre 2006 (2006-11-21), pages R439-R459, XP002663013, ISSN: 0022-3727

## Description

La présente invention se rapporte au domaine de la synthèse des matériaux composites nanostructurés.

Ces matériaux sont formés par des nanoparticules enrobées dans une matrice.

Par nanoparticules, on entend des particules, généralement solides, dont la taille est comprise entre 1 nm et quelques centaines de nanomètres. Par exemple, la taille des nanoparticules concernées peut être comprise entre 1 nm et 200nm.

Les matériaux composites nanostructurés présentent des propriétés singulièrement différentes de celles du même matériau à l'état massif, en particulier en fonction de la taille des nanoparticules enrobées dans la matrice.

Par exemple, il est généralement nécessaire de prévoir des nanoparticules de taille inférieure à 10nm pour modifier les propriétés électroniques et chimiques de ce matériau. Selon un autre exemple, il est généralement nécessaire d'avoir des nanoparticules de taille inférieure à 100nm pour modifier les propriétés mécaniques du matériau (ténacité, dureté, plasticité, ... ).

Il existe différentes techniques pour former de tels matériaux sur une surface cible.

L'une d'entre elles consiste à coupler deux systèmes distincts, l'un pour déposer les nanoparticules sur la surface cible, l'autre pour déposer la matrice sur cette surface cible, matrice dans laquelle les nanoparticules sont destinées à être enrobées.

Un dispositif de synthèse d'un matériau composite nanostructuré appartenant à cette technique est proposé dans l'article « Ferromagnetic, Transparent and Conducting ITO-Fe-Cluster Composite Films », D. L. Peng & al., IEEE Transactions on Magnetics, vol. 41, n°10, pp. 3406 à 3408, Octobre 2005.

Dans cet article, le dispositif comprend principalement trois régions: une première région formée par une chambre de pulvérisation, une deuxième région dans laquelle les nanoparticules croissent et dont la taille peut être contrôlée et une troisième région formée par une chambre de dépôt dans laquelle la synthèse du matériau est réalisée.

Les deux premières régions peuvent être assimilées à un premier système pour le dépôt des nanoparticules sur la surface cible.

La troisième région est assimilable à un deuxième système pour déposer la matrice, lequel est situé dans la chambre de synthèse.

Le couplage entre les deux systèmes s'effectue par l'intermédiaire d'un écorceur (« skimmer » selon la terminologie anglo-saxonne) par lequel les nanoparticules peuvent entrer dans la chambre de synthèse afin d'être déposées sur la surface cible. Cet écorceur permet de maintenir un différentiel de pression entre les deux systèmes qu'il sépare pour faciliter l'entrée des nanoparticules dans la chambre de synthèse.

Le premier système comprend des moyens pour générer un jet de gaz porteur entraînant les nanoparticules. Plus précisément, ces moyens comprennent une chambre de pulvérisation pour générer les nanoparticules et une source de gaz porteur, tel que l'Argon.

La chambre de pulvérisation utilise en l'occurrence une technique de condensation de vapeur générée par plasma (dite PGC pour Plasma-Gas-Condensation selon la terminologie anglo-saxonne).

La chambre de pulvérisation comprend un prolongement dans lequel les nanoparticules ainsi générées peuvent croître.

Le premier système comprend également une chambre intermédiaire, reliée à la chambre de pulvérisation par un écorceur. Une fois généré, le jet de gaz porteur entraînant les nanoparticules sort alors de la chambre de pulvérisation, traverse la chambre intermédiaire et entre finalement dans la chambre de synthèse, afin de permettre le dépôt des nanoparticules sur la surface cible. La chambre intermédiaire comporte ainsi un écorceur en entrée et un écorceur en sortie, afin de maintenir un grand différentiel de pression entre la chambre de pulvérisation et la chambre de synthèse.

A cet effet, la pression dans la chambre intermédiaire est inférieure à la pression dans la chambre de pulvérisation. La pression dans la chambre de synthèse est également inférieure à la pression dans la chambre intermédiaire.

Sans cette baisse de pression successive entre la chambre de pulvérisation et la chambre de synthèse, le jet de gaz porteur entraînant les nanoparticules pourrait difficilement atteindre la surface cible, ou atteindrait cette surface cible avec une vitesse trop faible pour réaliser un dépôt de bonne qualité.

La fonction de la chambre intermédiaire consiste ainsi à transmettre le jet de gaz porteur entrainant les nanoparticules depuis la chambre de pulvérisation vers la chambre de synthèse par l'intermédiaire des deux écorceurs.

Du fait que la pression doit baisser successivement depuis la chambre de pulvérisation jusqu'à la chambre de synthèse, il en résulte que la pression dans la chambre de synthèse est relativement faible.

Pour cette raison, ce dispositif ne peut pas mettre en oeuvre n'importe quel type de système pour le dépôt de la matrice. En effet, ce dispositif doit mettre en oeuvre une pulvérisation cathodique avec une cathode spéciale de type « Helicon », permettant un fonctionnement à très faible pression. En l'occurrence, la pression dans la chambre de synthèse est maintenue à 0,013Pa.

Le dispositif divulgué dans cet article présente plusieurs limitations.

Une première limitation est liée au fait que la pression doit diminuer depuis la chambre de pulvérisation jusqu'à la chambre de synthèse pour que le jet de gaz porteur puisse entraîner les nanoparticules jusqu'à la surface cible située dans la chambre de synthèse.

Ceci implique que la pression régnant dans la chambre de synthèse est très faible.

Cette très faible pression dans la chambre de synthèse est à l'origine d'une deuxième limitation. En effet, l'emploi d'une pulvérisation cathodique spécifique, de type « Helicon », pour pouvoir déposer la matrice à très basse pression dans la chambre de synthèse est obligatoire.

Une troisième limitation est liée à la source de nanoparticules, laquelle fonctionne par condensation d'une vapeur générée par plasma. En effet, cette technique n'est envisageable que pour des nanoparticules métalliques. Dans cet article, les nanoparticules sont en fer.

Une quatrième limitation est liée à la structure du matériau composite nanostructuré finalement synthétisé. En effet, cet article propose des structures séquentielles où se succèdent des zones contenant des nanoparticules et des zones n'en contenant pas. Il n'est donc pas envisagé de synthétiser des matériaux composites nanostructurés dans lesquels les nanoparticules sont distribuées de façon homogène dans la matrice.

Un objectif de l'invention est de pallier l'une au moins des limitations mentionnées ci-dessus.

En particulier, un objectif de l'invention est de proposer un choix élargi de dispositif de dépôt de la matrice enrobant les nanoparticules.

En particulier, un autre objectif de l'invention est de proposer un dispositif de synthèse d'un matériau composite nanostructuré, avec lequel il est possible de synthétiser un matériau pour lequel le choix dans la nature chimique des nanoparticules et/ou dans la nature chimique de la matrice sont élargis.

En particulier également, un objectif de l'invention est encore de proposer un dispositif de synthèse d'un matériau composite nanostructuré, avec lequel il est envisageable de synthétiser des structures variées dans l'agencement des nanoparticules dans la matrice, notamment des structures plus homogènes.

L'invention vise également à proposer un procédé de synthèse associé.

Pour atteindre l'un au moins de ces objectifs, l'invention propose un dispositif de synthèse d'un matériau composite nanostructuré comprenant des nanoparticules enrobées dans une matrice, le dispositif comprenant une chambre de synthèse dudit matériau comportant un système de dépôt de la matrice sur une surface cible, le dispositif étant caractérisé en ce qu'il comprend :
- un système pour générer un jet supersonique de nanoparticules dans un gaz porteur, ledit système comportant une chambre de détente ;
- une chambre tampon disposée entre ledit système pour générer ce jet supersonique et la chambre de synthèse, la pression régnant dans la chambre tampon étant inférieure à la pression régnant dans la chambre de détente,
ledit jet supersonique de gaz porteur entraînant les nanoparticules étant ainsi destiné à traverser la chambre de détente puis la chambre tampon, de sorte que les nanoparticules traversent la chambre de synthèse jusqu'à la surface cible.

Le dispositif pourra prévoir d'autres caractéristiques techniques, prises seules ou en combinaison :
- le système pour générer un jet supersonique de nanoparticules dans un gaz porteur comprend également un réservoir comportant un mélange de nanoparticules et d'un gaz porteur, une tuyère ou une lentille aérodynamique située entre le réservoir et la chambre de détente et un moyen de pompage du fluide présent dans la chambre de détente ;
- la distance entre la tuyère ou la lentille aérodynamique d'une part, et un orifice d'entrée de la chambre tampon d'autre part, est comprise entre 1 mm et 60mm, de préférence entre 5mm et 30mm ;
- la distance entre la tuyère ou la lentille aérodynamique d'une part, et l'orifice d'entrée de la chambre tampon d'autre part, est réglable ;
- l'orifice d'entrée de la chambre tampon est un diaphragme destiné à limiter l'angle solide du jet supersonique de gaz porteur entraînant les nanoparticules ;
- le diaphragme est un écorceur circulaire de section conique et dont le diamètre situé à la pointe du cône est compris entre 0,1mm et 2mm ;
- la chambre tampon comprend une conductance, cette conductance permettant de limiter la diffusion de gaz entre la chambre de synthèse vers la chambre tampon, lorsque la pression dans la chambre de synthèse est supérieure à la pression dans la chambre tampon ;
- la conductance est un cylindre dont le diamètre est compris entre 1cm et 20cm et dont la longueur est comprise entre 1 cm et 60cm ;
- l'orifice de sortie de la chambre tampon est un diaphragme dont le diamètre est compris entre 0,1mm et 50mm ;
- le diaphragme est logé dans la conductance ;
- la conductance s'étend au moins en partie dans la chambre de synthèse, en direction de la surface cible ;
- la chambre de synthèse comprend au moins un dispositif pour introduire un gaz dans cette chambre ;
- les conditions de fonctionnement suivantes sont prévues : la pression dans la chambre de détente est comprise entre 0,01 Pa et 10Pa, la pression dans la chambre tampon est comprise entre 0,0001 Pa et 0,01 Pa ;
- la pression dans la chambre de synthèse est comprise entre 0,001 Pa et 10Pa, de préférence entre 0,1 Pa et 1 Pa.

Pour atteindre l'un au moins de ces objectifs, l'invention propose également un procédé de synthèse d'un matériau composite nanostructuré comprenant des nanoparticules enrobées dans une matrice caractérisé en ce qu'il comprend les étapes suivantes :
(a) déposer une matrice pour ledit matériau dans une chambre de synthèse dudit matériau sur une surface cible;
(b) générer un jet supersonique de nanoparticules dans un gaz porteur avec un système comprenant une chambre de détente; et
(c) déposer les nanoparticules sur la surface cible située dans la chambre de synthèse, le jet supersonique de gaz porteur entraînant les nanoparticules à travers la chambre de détente et la chambre tampon dans laquelle règne une pression inférieure à la pression régnant dans la chambre de détente de sorte que les nanoparticules traversent la chambre de synthèse jusqu'à la surface cible.

Le procédé pourra prévoir d'autres caractéristiques techniques, prises seules ou en combinaison :
- la pression dans la chambre de détente est comprise entre 0,01 Pa et 10Pa et la pression dans la chambre tampon est comprise entre 0,0001 Pa et 0,01 Pa ;
- la pression dans la chambre de synthèse est comprise entre 0,001 Pa et 10Pa, de préférence entre 0,1 Pa et 1 Pa ;
- l'étape (a) est effectuée par pulvérisation cathodique, par dépôt physique en phase vapeur ou par dépôt chimique en phase vapeur, éventuellement assisté par plasma ;
- on chauffe la surface cible ;
- on ajuste la pression dans la chambre de synthèse par l'introduction d'un gaz neutre ;
- on introduit au moins un gaz précurseur dans la chambre de synthèse ;
- on dépose les nanoparticules et la matrice sur la surface cible en même temps ;
- on dépose les nanoparticules et la matrice sur la surface cible, séquentiellement.

D'autres caractéristiques, buts et avantages de l'invention seront énoncés dans la description détaillée ci-après faite en référence aux figures qui représentent, respectivement :
- la figure 1 est un schéma d'un dispositif de synthèse d'un matériau composite nanostructuré selon l'invention;
- la figure 2 est un schéma d'une variante de réalisation du dispositif représenté sur la figure 1.

Le dispositif 100 comprend une chambre de synthèse 3 du matériau composite nanostructuré. Ce matériau composite nanostructuré est réalisé à partir de nanoparticules enrobées dans une matrice.

Cette chambre de synthèse 3 comprend un système 13 de dépôt de la matrice sur une surface cible 15. Ce système de dépôt 13 de la matrice génère un flux d'atomes ou de molécules 14 destiné à être déposé sur la surface cible 15.

Elle comprend également un moyen de pompage 11, par exemple réalisé avec une ou plusieurs pompes turbomoléculaires, permettant d'atteindre une pression comprise entre 0,001 Pa et 10Pa dans la chambre de synthèse 3.

La chambre de synthèse 3 comprend également un moyen 12, formé d'une ou plusieurs vannes de précision ou d'un ou plusieurs débitmètres massiques, permettant l'entrée contrôlée dans la chambre de synthèse 3 d'un gaz supplémentaire.

Ce gaz supplémentaire peut être un gaz neutre tel que l'argon, l'azote ou un mélange de gaz neutres. L'introduction de ce gaz dans la chambre de synthèse 3 permet d'ajuster la pression dans cette chambre.

Ce gaz supplémentaire peut aussi être formé par un ou plusieurs gaz précurseurs dans le cas où le dépôt du matériau de la matrice est réalisé par dépôt chimique en phase vapeur (« PVD » pour « Physical Vapor Deposition » selon la terminologie anglo-saxonne), dépôt chimique en phase vapeur assisté par plasma (« PECVD » pour « Plasma Enhanced Chemical Vapor Deposition » selon la terminologie anglo-saxonne) ou par pulvérisation cathodique.

En utilisant une technique de dépôt de la matrice tout à fait classique, tels que la PVD, la PECVD ou la pulvérisation cathodique classique, la pression dans la chambre de synthèse 3 doit alors être suffisamment élevée pour permettre le fonctionnement du système de dépôt 13.

Par exemple, dans le cas d'un système de pulvérisation cathodique 13 classique, la pression minimum à atteindre dans la chambre de synthèse est de l'ordre de 0,1 Pa. La pression dans la chambre de synthèse 3 est ainsi comprise entre 0,1 Pa et 10Pa, avantageusement entre 0,1Pa et 1 Pa. Il convient de noter que des pressions trop élevées dans la chambre de synthèse limitent la taille maximale des nanoparticules qu'on peut déposer. Ainsi, pour une pression de l'ordre de 10Pa, on pourra généralement déposer des nanoparticules dont la dimension ne dépasse pas 100nm à 200nm.

Selon un autre exemple, le système de pulvérisation cathodique est de type pulvérisation magnétron impulsionnelle haute puissance (HIPIMS pour « High Power Magnetron Sputtering » selon la terminologie anglo-saxonne). Dans ce cas, la pression minimum à atteindre dans la chambre de synthèse 3 est de l'ordre de 0,05Pa. La pression dans la chambre de synthèse 3 est ainsi comprise entre 0,05Pa et 10Pa, avantageusement entre 0,05Pa et 1 Pa. Cette technique permet d'augmenter significativement les vitesses de dépôt.

Comme on peut le constater, le dispositif 100 permet une utilisation à des pressions plus élevées dans la chambre de synthèse 3, pouvant aller jusqu'à 10Pa. Cette dernière pression est largement plus élevée que la pression de fonctionnement dans la chambre de synthèse mettant en oeuvre une pulvérisation cathodique avec une cathode de type « Helicon » dans l'article de D.L. Peng & al.

Pour autant, le dispositif 100 pourrait également fonctionner à des pressions comparables aux pressions de fonctionnement nécessaires à la mise en oeuvre d'une pulvérisation cathodique de type « Helicon ».

Un intérêt du dispositif 100 selon l'invention réside donc dans le fait que le dispositif permet d'élargir les conditions de fonctionnement envisageables dans la chambre de synthèse 3. En particulier, il permet un fonctionnement à des pressions plus élevées dans la chambre de synthèse 3, par rapport au dispositif de Peng & al.

Cet avantage est lié au fait que le dispositif 100 comprend un système 1, 4, 5, 9 pour générer un jet supersonique 6a de gaz porteur entrainant les nanoparticules. En effet, le caractère supersonique du jet permet l'emploi d'un système de dépôt 13 de la matrice tout à fait classique dans la chambre de synthèse, comme cela sera expliqué de façon plus détaillée dans la suite de la description.

Ce système 1, 4, 5, 9 comprend un réservoir 4 qui contient un mélange de gaz porteur et de nanoparticules en suspension gazeuse. La pression et la température du gaz ainsi que la concentration de nanoparticules dans ce gaz sont ajustables.

Le réservoir 4 peut être un réacteur de synthèse fonctionnant par exemple par pyrolyse laser, ablation laser, évaporation sous vide, combustion ou être un générateur de nanoparticules par plasma. Il peut également s'agir d'un générateur d'aérosols nanométriques formés à partir d'une suspension de nanoparticules dans un liquide élaborée à l'avance ou à partir d'une poudre nanométrique sèche. Ces techniques ne présentent pas les limitations de la technique PGC quant aux matériaux utilisables pour les nanoparticules.

Ce système 1, 4, 5, 9 comprend également une chambre de détente 1 dans laquelle le gaz porteur contenant les nanoparticules est introduit à partir du réservoir 4. La pression dans la chambre de détente 1 est inférieure à la pression du réservoir 4.

Le passage du réservoir 4 à la chambre de détente 1 s'effectue par l'intermédiaire d'un moyen 5 pouvant être une tuyère ou une lentille aérodynamique.

Dans le cas d'une tuyère, il peut s'agir d'une tuyère de Laval, d'une tuyère conique, d'une tuyère sonique ou de tout autre orifice. Son diamètre peut être compris entre 0,1mm et 2mm. Son orifice peut être de forme circulaire, oblongue ou rectangulaire.

Dans le cas d'une lentille aérodynamique, ses caractéristiques peuvent être prévues pour obtenir un jet convergent, colinéaire ou divergent, en fonction de sa géométrie, des pressions à son entrée et à sa sortie, pour un diamètre aérodynamique équivalent donné de nanoparticules transportées par le gaz porteur, et suivant les caractéristiques du matériau nanostructuré recherchées.

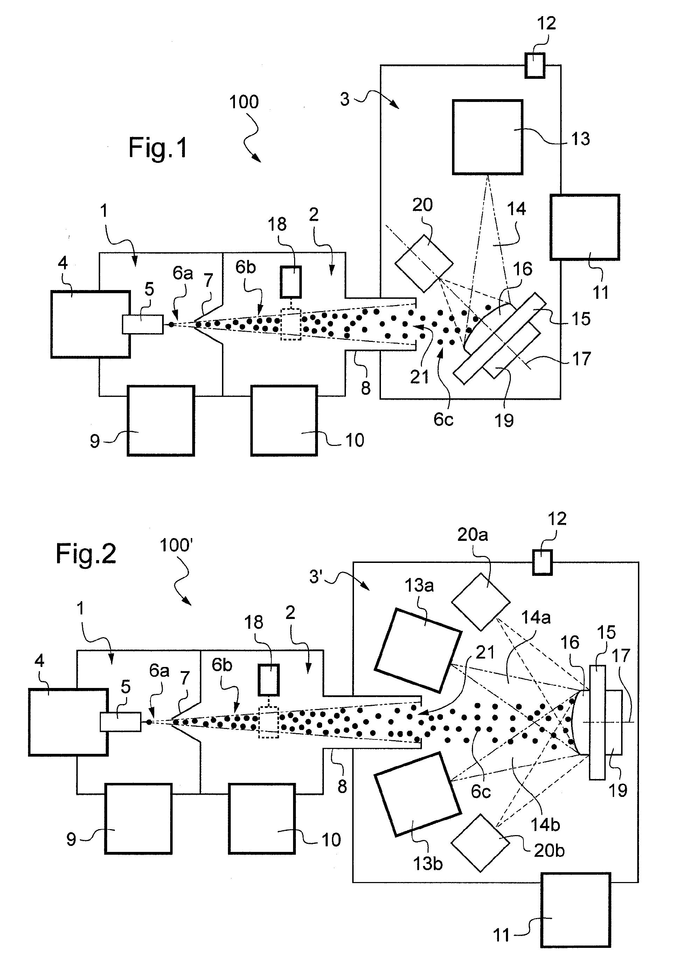

Dans le cas du dispositif 100 représenté sur la figure 1, le moyen 5 utilisé est une lentille aérodynamique divergente.

Le système 1, 4, 5, 9 comprend également un moyen de pompage 9, destiné à faire régner un vide poussé dans la chambre de détente 1. Le moyen de pompage 9 peut être formé d'une ou de plusieurs pompes turbomoléculaires ou d'une pompe dite « roots » multiétagée.

Une pression comprise entre 0,01 Pa et 10Pa est ainsi maintenue dans la chambre de détente 1. De préférence, cette pression est comprise entre 0,01 Pa et 0,2Pa pour faciliter la génération d'un jet supersonique sans avoir une pression excessivement élevée dans le réservoir 4.

Un système pour générer un jet supersonique de gaz porteur entraînant des nanoparticules est par exemple connu par l'article « Cluster beam synthesis of nanostructured thin films », Milani & al., J. Vac. Sci. Technol. A, Jul./Aug 2001. Dans cet article, le système fonctionne cependant avec une chambre de dépôt des nanoparticules à une pression très faible, qui ne pourrait pas permettre l'utilisation d'un système de dépôt d'une matrice pour matériau composite nanostructuré classique, par exemple de type pulvérisation cathodique classique, PVD ou PECVD.

Dans le cadre de l'invention, le couplage entre le système pour générer le jet supersonique de gaz porteur entrainant les nanoparticules 6a, 6b et la chambre de synthèse 3 du matériau composite nanostructuré est réalisé par l'intermédiaire d'une chambre tampon, dans laquelle règne une pression inférieure à la pression régnant dans la chambre de détente 1.

Le dispositif 100 comprend donc une chambre tampon 2 disposée entre la chambre de détente 1 et la chambre de synthèse 3.

Le jet 6a supersonique de gaz porteur contenant les nanoparticules est ainsi généré entre le réservoir 4 et la chambre de détente 1 à l'aide d'un premier différentiel de pression volontairement maintenu entre le réservoir 4 et la chambre de détente 1.

Il traverse ensuite la chambre de détente 1 jusqu'à un orifice d'entrée 7 de la chambre tampon 2. Cet orifice 7 permet de séparer la chambre tampon 2 de la chambre de détente 1.

Avantageusement, l'orifice d'entrée 7 de la chambre tampon 2 est un diaphragme qui présente alors une double fonction de séparation des chambres de détente 1 et tampon 2 et de limitation de l'angle solide du jet supersonique.

Le diaphragme 7 peut être circulaire ou rectangulaire. Il peut être de section plate ou conique.

Avantageusement, le diaphragme 7 est un écorceur. Cet écorceur peut être circulaire de section conique et dont le diamètre situé à la pointe du cône est compris entre 0,1mm et 2mm.

La distance minimum entre la tuyère ou la lentille aérodynamique 5 et l'orifice d'entrée 7 de la chambre tampon peut être comprise entre 1 mm et 60mm. Elle est préférentiellement choisie entre 5mm et 30mm. Elle peut être rendue réglable de l'extérieur en fonction des conditions de détente du jet supersonique par des moyens de réglage manuels ou motorisés (non représentés).

Il convient de noter que le jet moléculaire de gaz porteur entraînant les nanoparticules qui se propage dans la chambre de détente 1 est un jet supersonique en cours de formation. Le jet supersonique est définitivement formé dans la chambre tampon 2, après son passage à travers l'orifice 7. Les nanoparticules entraînées dans ce jet moléculaire de gaz au moment de son passage dans la chambre de détente 1 sont en réalité difficilement utilisables pour effectuer le dépôt sur la surface cible, si le jet ne passe pas vers la chambre tampon 2, à travers l'orifice 7.

Après son passage à travers l'orifice d'entrée 7 de la chambre tampon 2, le jet supersonique de gaz porteur 6a, définitivement formé et entraînant les nanoparticules, pénètre et traverse la chambre tampon 2.

Un intérêt de la chambre tampon 2 est d'extraire le jet supersonique de la détente qui s'est formée dans la chambre de détente 1 au passage de l'orifice 7, généralement un écorceur. Dans la chambre tampon, la littérature emploie alors le terme de « faisceau 6b » à la place du terme de « jet 6a » pour qualifier l'écoulement supersonique de gaz porteur. Par souci de simplification, on gardera cependant le terme de « jet » dans la suite de la description.

Un autre intérêt de la chambre tampon 2 est de maintenir un différentiel de pression entre la chambre de détente 1 et la chambre tampon 2, afin que le libre parcours moyen du gaz porteur composant le jet supersonique soit suffisant pour l'acheminer vers la chambre de synthèse 3. La pression dans la chambre tampon 2 est ainsi maintenue entre 0,0001 Pa et 0,01 Pa, par un moyen de pompage 10.

Ce moyen de pompage 10 peut être constitué par exemple d'une ou plusieurs pompes turbomoléculaires.

De cette façon, un deuxième différentiel de pression est volontairement appliqué entre la chambre de détente 1 et la chambre tampon 2.

Le jet supersonique 6b de gaz porteur contenant les nanoparticules ainsi formé traverse la chambre tampon 2 sans perturbation grâce à la faible pression régnant dans cette chambre 2.

Une mesure de la densité de nanoparticules présentes dans le jet supersonique 6b peut être effectuée dans la chambre tampon 2 à l'aide d'un moyen 18, avantageusement amovible, lequel peut être par exemple une balance à quartz ou un dispositif à fil chaud.

La chambre tampon 2 permet ainsi de transmettre le jet supersonique de nanoparticules depuis la chambre de détente 1 vers la chambre de synthèse 3, en sélectionnant, si on le souhaite, la taille des nanoparticules.

Le moyen 18 peut aussi être un filtre composé de hacheurs pour effectuer un tri en taille des nanoparticules qu'on souhaite déposer sur la surface cible 15 ou pour ralentir la vitesse de dépôt des nanoparticules.

La chambre tampon 2 peut comporter une conductance 8 pour limiter la diffusion de gaz entre la chambre de synthèse 3 et la chambre tampon 2, lorsque la pression dans la chambre de synthèse 3 est supérieure à la pression dans la chambre tampon 2. Cela permet de conserver une pression suffisamment basse dans la chambre tampon 2 en sollicitant moins le moyen de pompage 10.

La conductance 8 peut être constituée d'un cylindre de diamètre compris entre 1 cm et 20cm et de longueur comprise entre 1 cm et 60cm.

A ce cylindre, on peut éventuellement adjoindre un diaphragme de diamètre compris entre 0,1mm et 50mm et placé soit à l'une quelconque des deux extrémités de la conductance 8, soit en un point situé entre ses deux extrémités.

Au niveau de l'orifice de sortie 21 de la chambre tampon 2, (lequel correspond à l'orifice de sortie de la conductance 8 lorsqu'une telle conductance est prévue), la partie purement gazeuse du jet supersonique est détériorée et les atomes ou les molécules constituant le gaz porteur sont diffusés au voisinage de l'entrée de la chambre de synthèse 3, lorsque la pression régnant dans cette dernière est suffisamment élevée pour permettre la mise en oeuvre d'une technique de dépôt classique de la matrice (PVD, PECVD ou pulvérisation cathodique classique, etc...). Il convient de noter que, dans de telles conditions, le jet supersonique de gaz n'atteint pas le substrat 15, car les atomes ou molécules formant le gaz sont rapidement diffusés à l'entrée de la chambre de synthèse 3 du fait de la pression qui y règne.

Les inventeurs se sont en revanche aperçus que les nanoparticules continuaient leur chemin en direction de la surface cible 15, malgré la dégradation du jet de gaz porteur.

Selon les inventeurs, il est probable que l'énergie cinétique acquise par les nanoparticules dans la chambre de détente 1, conservée dans la chambre tampon 2, est suffisante pour qu'elles atteignent la surface cible 15, sans être trop perturbées par les collisions nombreuses avec le gaz à pression relativement élevée qui est présent dans la chambre de synthèse 3. En effet, chaque nanoparticule présente une énergie cinétique comprise entre plusieurs centaines d'eV et plusieurs milliers d'eV selon sa taille.

On peut en effet noter que les nanoparticules ont une inertie beaucoup plus importante que l'inertie des atomes ou molécules formant le gaz, si bien que la trajectoire des nanoparticules est beaucoup moins sensible aux collisions entre ces nanoparticules et le gaz présent dans la chambre de synthèse 3.

Dans les dispositifs connus, les nanoparticules sont toujours entraînées avec le gaz porteur jusqu'à la surface cible. En effet, il a toujours été considéré que la dégradation du jet de gaz porteur modifierait les caractéristiques du flux de nanoparticules.

La pression régnant dans la chambre de synthèse 3 peut ainsi être élevée et par suite, supérieure voire largement supérieure à la pression régnant dans la chambre tampon 2, lorsqu'un système de dépôt 13 classique est employé. Pour autant, l'invention n'interdit pas que la pression dans la chambre de synthèse 3 soit inférieure à la pression régnant dans la chambre intermédiaire avec d'autres dispositifs de dépôt 13 de la matrice.

Pour faciliter le parcours du jet de nanoparticules 6c dans la chambre de synthèse 3, une partie de la conductance 8 peut s'avancer à l'intérieur de la chambre de synthèse 3, en direction de la surface cible 15, de manière à limiter la distance parcourue par les nanoparticules dans la chambre de synthèse 3 entre l'orifice de sortie 21 de la conductance 8 et la surface cible 15.

En effet, il est préférable que la distance entre l'orifice de sortie 21 de la conductance 8 et la surface cible 15 soit minimum pour limiter le nombre de collisions entre les nanoparticules et les atomes ou les molécules de gaz présents sur le trajet des nanoparticules dans la chambre de synthèse 3. Ceci est également vrai lorsqu'aucune conductance n'est prévue à l'extrémité de la chambre tampon 2.

Par exemple, pour une distance entre l'orifice de sortie 21 de la conductance 8 (ou le cas échéant entre l'orifice de sortie 21 de la chambre tampon 2 et la surface cible 15) de l'ordre de 20cm, la pression dans la chambre de synthèse 3 doit être au maximum de 1 Pa, c'est-à-dire comprise entre 0,001 Pa et 1 Pa. Une pression de 1 Pa permet l'utilisation d'un système de dépôt classique, choisi parmi l'un de ceux mentionnés précédemment.

Le dispositif 100 selon l'invention prévoit donc des systèmes de dépôt différents sur une même surface cible 15. Un premier système de dépôt permet de déposer des nanoparticules sur la surface cible, l'autre permettant de déposer la matrice dans laquelle les nanoparticules seront enrobées pour former le matériau composite nanostructuré 16.

Les natures chimiques des nanoparticules d'une part et de la matrice d'autre part peuvent être choisies indépendamment l'une de l'autre. Le dispositif 100 offre ainsi une grande souplesse dans le choix des matériaux utilisables pour les nanoparticules d'une part et la matrice d'autre part. Ceci est principalement lié au fait que la génération du jet supersonique de gaz porteur entraînant les nanoparticules et le dépôt de la matrice dans la chambre de synthèse sont indépendants l'un de l'autre.

La chambre de synthèse 3 peut alors utiliser des techniques de dépôt classiques facilitant le dépôt de tous types de matériaux pour la matrice, techniques telles que la pulvérisation cathodique, la PVD ou la PECVD, en particulier la PECVD dite « basse pression ». Par PECVD basse pression, il faut ici comprendre que les pressions envisagées sont typiquement comprises entre 0,1 Pa et 1 Pa, les techniques PECVD dans leur généralité pouvant être employées jusqu'à des pressions de 1000Pa.

La surface cible 15 peut être animée d'un mouvement de rotation par des moyens de déplacement 19, manuels ou motorisés.

Ces moyens 19 peuvent permettre des mouvements de translation et de rotation de la surface cible 15 suivant tous les axes et dans toutes les directions.

Cela permet l'obtention de dépôts volontairement inhomogènes. Par exemple, il est possible, sur certaines zones de la surface cible 15, de composer des motifs de plus haute densité en nanoparticules.

L'inhomogénéité du dépôt de nanoparticules peut également être facilitée par le choix du jet supersonique, légèrement divergent, colinéaire ou convergent selon le cas. La forme de ce jet peut par exemple être déterminée par le choix de la lentille aérodynamique 5 choisie.

Ces moyens permettent plus simplement un déplacement en rotation de la surface cible 15 autour de son axe principal 17.

Cela permet des dépôts plus homogènes.

Par ailleurs, la liberté de positionnement de la surface cible offerte par les moyens 19, lesquels peuvent être disposés sur la face de ladite surface cible 15 opposée à la face sur laquelle le dépôt est effectué, permet de réaliser un co-dépôt des nanoparticules avec la matrice ou, au contraire, un dépôt séquentiel des nanoparticules et de la matrice.

Par exemple, la configuration représentée sur la figure 1 permet un co-dépôt de la matrice et des nanoparticules, dit angulaire.

Selon cette configuration dite angulaire, l'axe 17 normal à la surface cible 15 est placé entre l'axe de propagation du jet supersonique de nanoparticules et l'axe de propagation du faisceau 14 d'atomes ou de molécules générés par le système de dépôt 13 de la matrice.

Dans la configuration particulière présentée sur la figure 1, l'angle entre l'axe du faisceau 14 et l'axe de propagation du jet supersonique de nanoparticules est de 90° et, l'axe normal 17 à la surface cible 15 forme un angle de 45° par rapport à chacun de ces axes. Ceci permet le co-dépôt de la matrice et des nanoparticules.

Il est également possible d'effectuer un dépôt séquentiel avec le dispositif représenté sur la figure 1. En effet, pour effectuer un dépôt séquentiel de la matrice et des nanoparticules, on dispose l'axe normal 17 de la surface cible 15, avec les moyens de déplacement 19 de cette surface cible 15, séquentiellement, parallèlement à l'axe du faisceau 14 ou à l'axe du jet supersonique 6c de nanoparticules.

Un dépôt séquentiel permet, par exemple, d'élaborer des motifs de haute densité en nanoparticules en deux ou en trois dimensions sur la surface cible 15. Un dépôt séquentiel permet également d'élaborer des dépôts multicouches composés de différents matériaux, en particulier en ce qui concerne la nature des nanoparticules.

La chambre de synthèse 3 peut également comprendre un moyen de chauffage 20, avantageusement disposé en vis-à-vis de la face de la surface cible 15 sur laquelle la synthèse du matériau composite nanostructuré est réalisée.

En portant la surface cible 15 à des températures plus élevées que la température ambiante, on peut alors maîtriser la porosité et la structure aux échelles micrométriques et nanométriques du matériau composite nanostructuré finalement obtenu.

Le moyen de chauffage 20 de la surface cible 15 peut fonctionner par conduction. Dans ce cas, on positionne le moyen de chauffage 20, par exemple une résistance électrique, sur la face arrière du substrat 15, cette face arrière étant la face du substrat 15 opposée à la face sur laquelle le dépôt s'effectue.

En variante, le moyen de chauffage 20 peut fonctionner par rayonnement électromagnétique ou par bombardement électronique, comme cela est représenté sur la figure 1.

Dans le cas d'un chauffage par rayonnement électromagnétique, le moyen de chauffage 20 peut être un laser, impulsionnel ou continu, une lampe éventuellement équipée d'un dispositif de focalisation et/ou de filtration spectrale, ou toute autre source de rayonnement électromagnétique.

Une variante100' de réalisation du dispositif 100 de la figure 1 est représentée sur la figure 2.

Le dispositif 100' se distingue du dispositif 100 par le seul contenu de la chambre de synthèse 3'.

En effet, le système 4, 1, 5, 9 pour générer le jet supersonique de nanoparticules dans un gaz porteur et la chambre tampon 2 ne sont pas modifiés. La description faite précédemment s'applique donc également au dispositif 100'.

Dans cette variante, la configuration de la chambre de synthèse 3' est réalisée pour effectuer un dépôt dit concentrique, lequel peut être un co-dépôt ou un dépôt séquentiel de la matrice et des nanoparticules.

Dans cette configuration, l'axe normal 17 à la surface cible 15 est confondu avec l'axe de propagation du jet de nanoparticules 6c.

Cette configuration peut inclure un ou plusieurs systèmes de dépôt 13a, 13b, qui peuvent être identiques.

Une version particulière de cette configuration comporte deux dispositifs de dépôt 13a, 13b de la matrice.

Comme représenté sur la figure 2, les axes de propagation des atomes ou molécules 14a, 14b générés par ces systèmes de dépôt 13a, 13b sont placés à des angles compris entre 0° et 90° par rapport à l'axe de propagation du jet de nanoparticules 6c.

Cette variante de réalisation présente un intérêt lorsque l'on souhaite augmenter la vitesse de synthèse du matériau composite nanostructuré. Elle permet également de déposer plusieurs matériaux de natures chimiques différentes pour la matrice, en même temps ou de manière séquentielle.

En variante (non représentée), on pourrait inclure également un ou plusieurs systèmes de dépôts de géométrie annulaire et percés en leurs centres pour laisser passer le jet supersonique de nanoparticules. Cette variante peut être particulièrement intéressante sur le plan industriel, car elle permet d'augmenter encore plus la vitesse de synthèse du matériau composite nanostructuré, en augmentant la vitesse de dépôt de la matrice.

La représentation de la figure 2 montre le dispositif en fonctionnement, lors d'un co-dépôt de la matrice et des nanoparticules sur la surface cible 15. Le moyen 5 utilisée est en l'occurrence une lentille aérodynamique divergente.

Un dépôt séquentiel pourrait être envisagé, en faisant fonctionner séquentiellement les systèmes de dépôt 13a, 13b de la matrice d'une part, et le système pour générer le jet supersonique de nanoparticules d'autre part.

Le dépôt, simple ou réactif, séquentiel ou simultané, de plusieurs matériaux constituant la matrice permet d'obtenir des profils chimiques complexes de la matrice suivant l'épaisseur de la couche.

En particulier, on peut alors synthétiser un matériau composite nanostructuré avec une matrice de composition chimique variable en fonction de l'épaisseur. Une application intéressante concernerait la fabrication de jonctions nanostructurées dans le domaine de la microélectronique, par exemple des jonctions de type p-n pour des diodes, transistors ou cellules photovoltaïques à base de silicium.

Bien entendu, pour faire fonctionner le dispositif 100', la pression dans la chambre tampon 2 est inférieure ou égale à la fois à la pression dans la chambre de détente 1 et dans la chambre de synthèse 3'.

Avec les dispositifs 100, 100' décrits précédemment, il est alors possible de mettre en oeuvre un procédé de synthèse d'un matériau composite nanostructuré 16 comprenant des nanoparticules enrobées dans une matrice comprenant les étapes suivantes :
(a) déposer la matrice pour ledit matériau dans la chambre de synthèse 3, 3' dudit matériau sur la surface cible 15;
(b) générer le jet supersonique de gaz porteur entraînant les nanoparticules avec le système 1, 4, 9, 5 comprenant notamment la chambre de détente 1; et
(c) déposer les nanoparticules sur la surface cible 15 située dans la chambre de synthèse 3, 3', le jet supersonique de gaz porteur entraînant les nanoparticules à travers la chambre de détente 1 et la chambre tampon 2 dans laquelle règne une pression inférieure à la pression régnant dans la chambre de détente 1 de sorte que les nanoparticules traversent la chambre de synthèse 3, 3' jusqu'à la surface cible 15.

Les pressions dans chacune des trois chambres pourront être comme suit. La pression dans la chambre de détente 1 est comprise entre 0,01 Pa et 10Pa, de préférence entre 0,01 Pa et 0,2Pa, la pression dans la chambre tampon 2 est comprise entre 0,0001 Pa et 0,01 Pa et la pression dans la chambre de synthèse 3, 3' est comprise entre 0,001 Pa et 10Pa.

En particulier, la pression dans la chambre de détente est avantageusement comprise entre 0,01 Pa et 0,2Pa, pour les raisons déjà mentionnées précédemment. En particulier également, la pression régnant dans la chambre de synthèse 3 pourra être comprise entre 0,05Pa et 10Pa, avantageusement entre 0,1Pa et 1 Pa. Ceci permet de mettre en oeuvre un système de dépôt classique, choisi parmi l'un de ceux décrits précédemment.

L'étape (a) peut être effectuée par pulvérisation cathodique classique, par dépôt physique en phase vapeur ou par dépôt chimique en phase vapeur, éventuellement assisté par plasma. En particulier, on peut utiliser un dépôt chimique en phase vapeur assisté par plasma, dit à basse « pression » comme défini précédemment.

On peut chauffer la surface cible 15 pour maîtriser la porosité et la structure aux échelles micrométriques et nanométriques du matériau composite nanostructuré finalement obtenu.

On peut également ajuster la pression dans la chambre de synthèse 3, 3' par l'introduction d'un gaz neutre tel que l'argon, l'azote ou un mélange de gaz neutres.

On peut encore introduire un ou plusieurs gaz précurseurs dans le cas où le dépôt du matériau de la matrice est réalisé par dépôt chimique en phase vapeur, éventuellement assisté par plasma (« PECVD » pour « Plasma Enhanced Chemical Vapor Deposition » selon la terminologie anglo-saxonne) ou par pulvérisation cathodique classique.

Enfin, et comme mentionné précédemment, on pourra déposer les nanoparticules et la matrice sur la surface cible 15 en même temps ou, au contraire, séquentiellement.

Le dispositif selon l'invention est particulièrement prometteur. En effet, le contexte économique qui motive la réalisation de nouveaux matériaux composites nanostructurés est extrêmement vaste. Ceci est lié à la diversité des matériaux envisageables pour les nanoparticules et la matrice. Ainsi, le champ d'application de l'invention peut être très étendu dans ses applications.

Il peut par exemple s'agir du domaine actuellement très porteur de la production et du stockage de l'énergie, du stockage d'informations, du traitement de surface pour conférer de nouvelles propriétés aux supports (autonettoyant, autocicatrisant, résistant à l'abrasion...).

En particulier, une des applications envisagées avec le dispositif 100, 100' selon l'invention se situe dans le domaine de la conversion du rayonnement solaire en électricité.

Les cellules solaires photovoltaïques actuelles utilisent pour la plupart le silicium cristallin comme matériau de conversion. L'application visée consisterait en une cellule solaire tout silicium à haut rendement. On envisage pour cela une cellule dite tandem dans laquelle une jonction réalisée avec un matériau composite nanostructuré à base de cristaux de silicium est juxtaposée à une jonction monocristalline classique.

Pour limiter la thermalisation des porteurs générés par les photons énergétiques, le gap du matériau composite nanostructuré peut être ajusté à une valeur cible proche de 1,7eV en fonction de la taille des nanoparticules, en l'occurrence des nanocristaux. Le rendement théorique d'une telle cellule tandem a été déterminée comme étant est proche de 42%, qu'il faut comparer au rendement de 24% d'une cellule silicium classique, obtenu en laboratoire. La jonction réalisée avec un matériau composite nanostructuré serait composée de nanoparticules de silicium cristallines de taille contrôlée enrobées dans une matrice de SiO₂ Si₃N₄ ou SiC.

D'autres applications utilisant d'autres matériaux pour les nanoparticules et pour la matrice, comme par exemple les céramiques ou le diamant, sont visées dans les domaines du renfort mécanique de surface par dépôts nanostructurés ou des matériaux auto-réparants, par exemple.

Les matériaux composites nanostructurés à matrice métallique sont utilisés dans l'industrie de l'automobile (Al / SiC), de la microélectronique (Al / AlN ou Al₂O₃), du magnétisme (Fe / MgO), de la catalyse (Fe / TiN), des matériaux de structure (acier ODS, Nb / Cu), de l'électrochimie (Ni / TiO₂).

Les matériaux composites nanostructurés à matrice céramique sont rencontrés dans les domaines de la catalyse (TiO₂ / Pt), des fibres optiques (SiO₂ / Co), des matériaux de structure (Al₂O₃ ou Si₃N₄ / SiC), des matériaux luminescents (Al₂O₃ / NdAlO₃), du magnétisme (TiO₂ / Fe₂O₃).

## Revendications

1. Dispositif (100, 100') de synthèse d'un matériau composite nanostructuré (16) comprenant des nanoparticules enrobées dans une matrice, le dispositif comprenant une chambre de synthèse (3, 3') dudit matériau comportant un système (13, 13a, 13b) de dépôt de la matrice sur une surface cible (15), le dispositif étant **caractérisé en ce qu'**il comprend :
- un système (1, 4, 5, 9) pour générer un jet supersonique de nanoparticules dans un gaz porteur, ledit système comportant une chambre de détente (1) ; et
- une chambre tampon (2) disposée entre ledit système (1, 4, 5, 9) pour générer ce jet supersonique et la chambre de synthèse (3, 3'), la pression régnant dans la chambre tampon (2) étant inférieure à la pression régnant dans la chambre de détente (1),
ledit jet supersonique de gaz porteur entraînant les nanoparticules étant ainsi destiné à traverser la chambre de détente (1) puis la chambre tampon (2), de sorte que les nanoparticules traversent la chambre de synthèse (3, 3') jusqu'à la surface cible (15).

2. Dispositif selon la revendication 1, dans lequel le système (1, 4, 5, 9) pour générer un jet supersonique de nanoparticules dans un gaz porteur comprend également:
- un réservoir (4) comportant un mélange de nanoparticules et d'un gaz porteur ;
- une tuyère ou une lentille aérodynamique (5) située entre le réservoir (4) et la chambre de détente (1) ;
- un moyen de pompage (9) du fluide présent dans la chambre de détente (1).

3. Dispositif selon la revendication précédente, dans lequel la distance entre la tuyère ou la lentille aérodynamique (5) d'une part, et un orifice d'entrée (7) de la chambre tampon (2) d'autre part, est réglable, par exemple entre 1 mm et 60mm.

4. Dispositif selon la revendication précédente, dans lequel l'orifice d'entrée (7) de la chambre tampon (2) est un diaphragme destiné à limiter l'angle solide du jet supersonique de gaz porteur entraînant les nanoparticules.

5. Dispositif selon l'une des revendications précédentes, dans lequel la chambre tampon (2) comprend une conductance (8), cette conductance (8) permettant de limiter la diffusion de gaz entre la chambre de synthèse (3, 3') vers la chambre tampon (2), lorsque la pression dans la chambre de synthèse (3, 3') est supérieure à la pression dans la chambre tampon (2).

6. Dispositif selon l'une des revendications précédentes, dans lequel l'orifice de sortie (21) de la chambre tampon (2) est un diaphragme dont le diamètre est compris entre 0,1 mm et 50mm.

7. Dispositif selon la revendication précédente, dans lequel le diaphragme (21) est logé dans la conductance (8).

8. Dispositif selon l'une des revendications 5 à 7, dans lequel la conductance (8) s'étend au moins en partie dans la chambre de synthèse (3, 3'), en direction de la surface cible (15).

9. Dispositif selon l'une des revendications précédentes, dans lequel la chambre de synthèse (3, 3') comprend au moins un dispositif (12) pour introduire un gaz dans cette chambre (3, 3').

10. Procédé de synthèse d'un matériau composite nanostructuré (16) comprenant des nanoparticules enrobées dans une matrice, **caractérisé en ce qu'**il comprend les étapes suivantes :
(a) déposer une matrice pour ledit matériau dans une chambre de synthèse (3, 3') dudit matériau, sur une surface cible (15);
(b) générer un jet supersonique de nanoparticules dans un gaz porteur avec un système (1, 4, 9, 5) comprenant une chambre de détente (1); et
(c) déposer les nanoparticules sur la surface cible (15) située dans la chambre de synthèse (3, 3'), le jet supersonique de gaz porteur entraînant les nanoparticules à travers la chambre de détente (1) et la chambre tampon (2) dans laquelle règne une pression inférieure à la pression régnant dans la chambre de détente (1) de sorte que les nanoparticules traversent la chambre de synthèse (3, 3') jusqu'à la surface cible (15}.

11. Procédé selon la revendication précédente, dans lequel
- la pression dans la chambre de détente (1) est comprise entre 0,01 Pa et 10Pa;
- la pression dans la chambre tampon (2) est comprise entre 0,0001 Pa et 0,01 Pa.

12. Procédé selon l'une des revendications 10 ou 11, dans lequel la pression dans la chambre de synthèse (3, 3') est comprise entre 0,001 Pa et 10Pa, de préférence entre 0,1 Pa et 1Pa.

13. Procédé selon l'une des revendications 10 à 12, dans lequel l'étape (a) est effectuée par pulvérisation cathodique, par dépôt physique en phase vapeur ou par dépôt chimique en phase vapeur, éventuellement assisté par plasma.

14. Procédé selon l'une des revendications 10 à 13, dans lequel on chauffe la surface cible (15).

15. Procédé selon l'une des revendications 10 à 14, dans lequel on dépose les nanoparticules et la matrice sur la surface cible (15) en même temps ou, selon le cas, séquentiellement.

## Patentansprüche

1. Vorrichtung (100, 100') zur Synthese eines Komposit-Nanostruktur-Materials (16), das Nanopartikel enthält, die in einer Matrix eingebettet sind, wobei die Vorrichtung eine Synthesekammer (3, 3') des Materials umfasst, die mit einem System (13, 13a, 13b) zur Abscheidung der Matrix auf einer Zielfläche (15) ausgestattet ist, wobei die Vorrichtung **dadurch gekennzeichnet ist, dass** sie umfasst:
- ein System (1, 4, 5, 9) zum Erzeugen eines Überschalfstrahls aus Nanopartikeln in einem Trägergas, wobei das System eine Entspannungskammer (1) umfasst; und
- eine Pufferkammer (2), die zwischen dem System (1, 4, 5, 9) zum Erzeugen des Überschallstrahls und der Synthesekammer (3, 3') angeordnet ist, wobei der in der Pufferkammer (2) herrschende Druck niedriger als der in der Entspannungskammer (1) herrschende Druck ist,
wobei der Überschallstrahl des Trägergases die Nanopartikel mitnimmt, die somit erst die Entspannungskammer (1), dann die Pufferkammer (2) derart durchqueren, dass die Nanopartikel die Synthesekammer (3, 3') bis zu der Zielfläche (15) durchqueren.

2. Vorrichtung nach Anspruch 1, wobei das System (1, 4, 5, 9) zum Erzeugen eines Überschallstrahls aus Nanopartikeln in einem Trägergas ferner umfasst:
- ein Reservoir (4), das eine Mischung aus Nanopartikeln und einem Trägergas enthält;
- einen Strahlregler oder eine aerodynamische Linse (5), der/die zwischen dem Reservoir (4) und der Entspannungskammer (1) angeordnet ist;
- ein Mittel zum Pumpen (9) des in der Entspannungskammer (1) vorhandenen Fluids.

3. Vorrichtung nach dem vorherigen Anspruch, wobei der Abstand zwischen dem Strahlregler oder der aerodynamischen Linse (5) einerseits und einer Eintrittsöffnung (7) der Pufferkammer (2) andererseits zum Beispiel zwischen 1 mm und 60 mm einstellbar ist.

4. Vorrichtung nach dem vorherigen Anspruch, wobei die Eintrittsöffnung (7) der Pufferkammer (2) eine Blende ist, die ausgelegt ist, einen Raumwinkel des Überschallstrahls aus Trägergas, der die Nanopartikel mitnimmt, zu begrenzen.

5. Vorrichtung nach einem der vorhergehenden Ansprüche, wobei die Pufferkammer (2) eine Strömungsleitvorrichtung (8) umfasst, wobei diese Strömungsleitvorrichtung (8) eine Begrenzung der Streuung des Gases zwischen der Synthesekammer (3, 3') in Richtung der Pufferkammer (2) ermöglicht, wenn der Druck in der Synthesekammer (3, 3') höher als der Druck in der Pufferkammer (2) ist.

6. Vorrichtung nach einem der vorherigen Ansprüche, wobei die Austrittsöffnung (21) der Pufferkammer (2) eine Blende ist, deren Durchmesser zwischen 0,1 mm und 50 mm beträgt.

7. Vorrichtung nach dem vorherigen Anspruch, wobei die Blende (21) in der Strömungsleitvorrichtung (8) angeordnet ist.

8. Vorrichtung nach einem der Ansprüche 5 bis 7, wobei sich die Strömungsleitvorrichtung (8) wenigstens teilweise in die Synthesekammer (3, 3'), in Richtung der Zielfläche (15) erstreckt.

9. Vorrichtung nach einem der vorherigen Ansprüche, wobei die Synthesekammer (3, 3') wenigstens eine Vorrichtung (12) zum Einleiten eines Gases in diese Kammer (3, 3') umfasst.

10. Verfahren zur Synthese eines Komposit-Nanostruktur-Materials (16), das Nanopartikel enthält, die in einer Matrix eingebettet sind, **dadurch gekennzeichnet, dass** es die folgenden Schritte umfasst:
(a) Abscheiden einer Matrix für das Material in einer Synthesekammer (3, 3') des Materials auf einer Zielfläche (15);
(b) Erzeugen eines Überschallstrahls aus Nanopartikeln in dem Trägergas mit einem System (1, 4, 9, 5), das eine Entspannungskammer (1) umfasst; und
(c) Abscheiden der Nanopartikel auf der Zielfläche (15), die in der Synthesekammer (3, 3') angeordnet ist, wobei der Überschallstrahl des Trägergases die Nanopartikel durch die Entspannungskammer (1) und die Pufferkammer (2), in der ein niedriger Druck herrscht als in der Entspannungskammer (1), mitnimmt, und zwar derart, dass die Nanopartikel die Synthesekammer (3, 3') bis zu der Zielfläche (15) durchqueren.

11. Verfahren nach dem vorhergehenden Anspruch, wobei:
- der Druck in der Entspannungskammer (1) zwischen 0,01 Pa und 10 Pa beträgt;
- der Druck in der Pufferkammer (2) zwischen 0,0001 Pa und 0,01 Pa beträgt.

12. Verfahren nach Anspruch 10 oder 11, wobei der Druck in der Synthesekammer (3, 3') zwischen 0,001 Pa und 10 Pa, vorzugsweise zwischen 0,1 Pa und 1 Pa, beträgt.

13. Verfahren nach einem der Ansprüche 10 bis 12, wobei der Schritt (a) durch Kathodenzerstäubung, durch physikalische Abscheidung aus der Dampfphase oder durch chemische Abscheidung aus der Dampfphase, gegebenenfalls unterstützt durch ein Plasma, bewerkstelligt wird.

14. Verfahren nach einem der Ansprüche 10 bis 13, wobei die Zielfläche (15) erhitzt wird.

15. Verfahren nach einem der Ansprüche 10 bis 14, wobei die Nanopartikel und die Matrix gleichzeitig oder, je nach Bedarf, nacheinander abgeschieden werden.

## Claims

1. Device (100, 100') for synthesising a nanostructured composite material (16) comprising nanoparticles coated in a matrix, the device comprising a synthesis chamber (3, 3') for said material comprising a system (13, 13a, 13b) for depositing the matrix on a target surface (15), the device being **characterised in that** it comprises:
- a system (1, 4, 5, 9) for generating a supersonic jet of nanoparticles in a carrier gas, said system comprising an expansion chamber (1); and
- a buffer chamber (2) arranged between said system (1, 4, 5, 9) for generating the supersonic jet and the synthesis chamber (3, 3'), the pressure prevailing in the buffer chamber (2) being lower than the pressure prevailing in the expansion chamber (1), said supersonic jet of carrier gas carrying the nanoparticles thus being intended to pass through the expansion chamber (1) and then the buffer chamber (2), so that the nanoparticles pass through the synthesis chamber (3, 3') to the target surface (15).

2. Device according to claim 1, wherein the system (1, 4, 5, 9) for generating a supersonic jet of nanoparticles in a carrier gas also comprises:
- a reservoir (4) containing a mixture of nanoparticles and a carrier gas;
- a nozzle or an aerodynamic lens (5) situated between the reservoir (4) and the expansion chamber (1);
- a pumping means (9) for the fluid present in the expansion chamber (1).

3. Device according to the preceding claim, wherein the distance between the nozzle or the aerodynamic lens (5), on the one hand, and an inlet orifice (7) of the buffer chamber (2), on the other hand, is adjustable, for example from 1 mm to 60 mm.

4. Device according to the preceding claim, wherein the inlet orifice (7) of the buffer chamber (2) is a diaphragm for limiting the solid angle of the supersonic jet of carrier gas carrying the nanoparticles.

5. Device according to any one of the preceding claims, wherein the buffer chamber (2) comprises a conductance (8), the conductance (8) allowing the diffusion of gas between the synthesis chamber (3, 3') and the buffer chamber (2) to be limited when the pressure in the synthesis chamber (3, 3') is greater than the pressure in the buffer chamber (2).

6. Device according to any one of the preceding claims, wherein the outlet orifice (21) of the buffer chamber (2) is a diaphragm, the diameter of which is from 0.1 mm to 50 mm.

7. Device according to the preceding claim, wherein the diaphragm (21) is housed in the conductance (8).

8. Device according to any one of claims 5 to 7, wherein the conductance (8) extends at least in part into the synthesis chamber (3, 3'), in the direction of the target surface (15).

9. Device according to any one of the preceding claims, wherein the synthesis chamber (3, 3') comprises at least one device (12) for introducing a gas into the chamber (3, 3').

10. Method for synthesising a nanostructured composite material (16) comprising nanoparticles coated in a matrix, **characterised in that** it comprises the following steps:
(a) depositing a matrix for said material in a synthesis chamber (3, 3') for said material, on a target surface (15);
(b) generating a supersonic jet of nanaparticles in a carrier gas using a system (1, 4, 9, 5) comprising an expansion chamber (1); and
(c) depositing the nanoparticles on the target surface (15) situated in the synthesis chamber (3, 3'), the supersonic jet of carrier gas carrying the nanoparticles through the expansion chamber (1) and the buffer chamber (2) in which there prevails a pressure lower than the pressure prevailing in the expansion chamber (1) so that the nanoparticles pass through the synthesis chamber (3, 3') to the target surface (15).

11. Method according to the preceding claims, wherein:
- the pressure in the expansion chamber (1) is from 0.01 Pa to 10 Pa;
- the pressure in the buffer chamber (2) is from 0.0001 Pa to 0.01 Pa.

12. Method according to either claim 10 or claim 11, wherein the pressure in the synthesis chamber (3, 3') is from 0.001 Pa to 10 Pa, preferably from 0.1 Pa to 1 Pa.

13. Method according to any one of claims 10 to 12, wherein step (a) is carried out by cathodic sputtering, by physical vapour deposition or by chemical vapour deposition, optionaily plasma-enhanced.

14. Method according to any one of claims 10 to 13, wherein the target surface (15) is heated.

15. Method according to any one of claims 10 to 14, wherein the nanoparticles and the matrix are deposited on the target surface (15) at the same time or, where appropriate, in succession.
